# EUROPEAN PATENT APPLICATION

(11) **EP 1 884 518 A1**
(43) Date of publication of application: **06.02.2008**
(21) Application number: 07113256.7
(22) Date of filing: 26.07.2007
(51) Int. Cl.: C07F 1/08, C07F 3/02, C07F 5/00, C07F 7/00, C07F 7/10, C07F 7/28, C07F 9/00, C07F 11/00, C07F 15/04, C23C 16/06

(54) **Metal-imino complexes suitable for use as vapor deposition precursors**

(30) Priority: 29.09.2006 US 540071; 31.07.2006 US 834480 P
(71) Applicant: Rohm and Haas Electronic Materials LLC, Marlborough, MA 01752 (US)
(72) Inventor: Shenai-Khatkhate, Deodatta Vinayak, Danvers, MA 01923 (US); Wang, Qing Min, North Andover, MA 01845-1320 (US)
(74) Representative: Buckley, Guy Julian

(57) **Abstract**

Certain organometallic compounds in the form of imino complexes are provided. Such complexes are particularly suitable for use as vapor deposition precursors. Also provided are methods of depositing thin films, such as by ALD and CVD, using such compounds.

## Description

The present invention relates generally to the field of organometallic compounds. In particular, the present invention relates to the field of organometallic compounds useful for atomic layer deposition and chemical vapor deposition of thin films.

In atomic layer deposition ("ALD") processes, conformal thin films are deposited by exposing a surface to alternating vapors of two or more chemical reactants. Vapor from a first precursor (or reactant) is brought to the surface onto which the desired thin film is to be deposited. Any unreacted vapor is then removed from the system under vacuum. Next, vapor from a second precursor is brought to the surface and allowed to react with the first precursor, with any excess second precursor vapor being removed. Each step in the ALD process typically deposits a monolayer of the desired film. This sequence of steps is repeated until the desired film thickness is obtained. In general, ALD processes are performed at fairly low temperatures, such as from 200 to 400° C. The exact temperature range will depend on the particular film to be deposited as well as on the particular precursors employed. ALD processes have been used to deposit pure metals as well as metal oxides, metal nitrides, metal carbide nitrides, and metal silicide nitrides.

ALD precursors must be sufficiently volatile to ensure a sufficient concentration of the precursor vapor in the reactor to deposit a monolayer on the substrate surface within a reasonable period of time. The precursors must also be sufficiently stable to be vaporized without premature decomposition and unwanted side reactions, but must also be sufficiently reactive to form the desired film on the substrate. With such a required balance of volatility and stability properties, there is an overall lack of suitable precursors.

Conventional precursors are homoleptic, i.e. they have a single ligand group. Homoleptic precursors offer uniform chemical characteristics, thus offering the inherent advantage of matching and harmonizing the functionality of ligand with the deposition process. However, the use of only a single ligand group offers less control over other paramount precursor characteristics, such as the shielding of metal center, that governs the surface reactions (e.g. chemisorption) and gas phase reaction (e.g. reaction with second complementary precursor), adjusting the volatility of precursor, and achieving required thermal stability for the precursor. For example, tetrakis(dialkylamino) hafnium is currently used as a chloride-free alternative to HfC1₄. However, precursors in this class of compounds tend to prematurely decompose during storage and/or before reaching the reactor. Substituting one or more of the dialkylamino groups with another organic group that imparts thermal stability has been tried but with little success, due to the inability to match the functionality of other group and achieve the desired stability. Certain metal imino complex compounds are known as vapor deposition precursors. For example, U.S. Patent Application No. 2005/0202171 (Shin) discloses certain metal imino complex compounds as suitable precursors for ALD. Such compounds may not provide the balance of volatility and thermal stability (or other properties) needed under certain ALD conditions. There remains a need for suitable and stable precursors that meet the deposition requirements and produce films that are essentially carbon-free.

The present invention provides an organometallic compound having the formula (EDG-(CR¹R²)_{y}-N=)ₙM^{+m}L¹_{x'}L²_{x"}L³ₚ, wherein each R¹ and R² are independently chosen from H, (C₁-C₆)alkyl and EDG; EDG is an electron donating group; M = a metal; L¹ = an anionic ligand; L² is a ligand chosen from amino, alkylamino, dialkylamino and alkoxyalkyldialkylamino; L³ = a neutral ligand; y = 0-6; m = the valence of M; n = 1-2; x' ≥ 0; x" ≥ 0; m = 2n + x' + x"; p = 0-3; wherein n = 1 when m = 2-3, and wherein n = 1-2 when m ≥ 4; L¹ ≠ L²; provided that x' ≥ 1 when m ≥ 3 and EDG = amino, alkylamino, dialkylamino, pyridyl or alkoxy.

Such compounds are suitable in a variety of vapor deposition methods, such as chemical vapor deposition ("CVD"), and are particularly suitable for ALD. Also provided is a composition including the above described organometallic compound and an organic solvent. Such a composition is particularly suitable for use in ALD and direct liquid injection processes.

The present invention further provides a method of depositing a film including the steps of: providing a substrate in a reactor; conveying the organometallic compound described above in a gaseous form to the reactor; and depositing a film including the metal on the substrate. In another embodiment, the present invention provides a method of depositing a film including the steps of: providing a substrate in a reactor; conveying as a first precursor the organometallic compound described above in a gaseous form to the reactor; chemisorbing the first precursor compound on the surface of the substrate; removing any non-chemisorbed first precursor compound from the reactor; conveying a second precursor in a gaseous form to the reactor; reacting the first and second precursors to form a film on the substrate; and removing any unreacted second precursor.

As used throughout this specification, the following abbreviations shall have the following meanings, unless the context clearly indicates otherwise: °C = degrees centigrade; ppm = parts per million; ppb = parts per billion; RT = room temperature; M = molar; Me = methyl; Et = ethyl; i-Pr = iso-propyl; t-Bu = tert-butyl; c-Hx = cyclohexyl; Cp = cyclopentadienyl; Py = pyridyl; BiPy = bipyridyl; COD = cyclooctadiene; CO = carbon monoxide; Bz = benzene; Ph = phenyl; VTMS = vinyltrimethylsilane; and THF = tetrahydrofuran.

"Halogen" refers to fluorine, chlorine, bromine and iodine and "halo" refers to fluoro, chloro, bromo and iodo. Likewise, "halogenated" refers to fluorinated, chlorinated, brominated and iodinated. "Alkyl" includes linear, branched and cyclic alkyl. Likewise, "alkenyl" and "alkynyl" include linear, branched and cyclic alkenyl and alkynyl, respectively. The articles "a" and "an" refer to the singular and the plural.

Unless otherwise noted, all amounts are percent by weight and all ratios are molar ratios. All numerical ranges are inclusive and combinable in any order except where it is clear that such numerical ranges are constrained to add up to 100%.

The organometallic compounds of the present invention, known generally as metal imino complexes, have the general formula (EDG-(CR¹R²)_{y}-N=)ₙM^{+m}L¹_{x'}L²_{x"}L³ₚ, wherein each R¹ and R² are independently chosen from H, (C₁-C₆)alkyl and EDG; EDG is an electron donating group; M = a metal; L¹ = an anionic ligand; L² is a ligand chosen from amino, alkylamino, dialkylamino and alkoxyalkyldialkylamino; L³ = a neutral ligand; y = 0-6; m = the valence of M; n = 1-2; x' ≥ 0; x" ≥ 0; m = 2n + x' + x"; p = 0-3; wherein n = 1 when m = 2-3, and wherein n = 1-2 when m ≥ 4; L¹ ≠ L²; provided that x' ≥ 1 when m ≥ 3 and EDG = amino, alkylamino, dialkylamino, pyridyl or alkoxy. In one embodiment, y = 0-3. The subscript "n" represents the number of imino complex ligands in the present compounds. The valence of M is typically 2-7 (i.e., typically m = 2-7), more typically 3-7, and still more typically 3-6. It will be appreciated by those skilled in the art that n = 1 or 2 when m ≥ 6. When the metal has a valence of ≤ 5 (i.e., m ≤ 5), n is typically 1. In general, x' = 0-5. When m = 2, x' = x" = 0. In general, x" = 0-5 and more typically 0-4. In one embodiment, each R¹ and R², R³ and R⁴ are independently chosen from H, methyl, ethyl, propyl, butyl, and an electron donating group ("EDG").

A wide variety of metals may suitably be used to form the present imino complexes. Typically, M is chosen from a Group 2 to Group 16 metal. As used herein, the term "metal" includes the metalloids boron, silicon, arsenic, selenium and tellurium but does not include carbon, nitrogen, phosphorus, oxygen and sulfur. In one embodiment, M = Be, Mg, Sr, Ba, Al, Ga, In, Si, Ge, Sb, Bi, Se, Te, Po, Cu, Zn, Sc, Y, La, a lanthanide metal, Ti, Zr, Hf, Nb, W, Mn, Co, Ni, Ru, Rh, Pd, Ir or Pt. In another embodiment, M = Al, Ga, In, Ge, La, a lanthanide metal, Ti, Zr, Hf, Nb, W, Mn, Co, Ni, Ru, Rh, Pd, Ir or Pt.

Suitable electron donating groups for EDG are any which provide π-electron stabilization to the metal. The electron donating groups may be any which include one or more of oxygen, phosphorus, sulfur, nitrogen, alkenes, alkynes and aryl groups. Salts of electron donating groups, such as their alkali or alkaline earth metal salts, may also be used. Exemplary electron donating groups include, without limitation, hydroxyl ("-OH"), (C₁-C₆)alkoxy ("-OR"), carbonyl ("-C(O)-"), carboxy ("-CO₂X"), carb(C₁-C₆)alkoxy ("-CO₂R"), carbonate ("-OCO₂R"), amino ("-NH₂"), (C₁-C₆)alkylamino ("-NHR"), di(C₁-C₆)alkylamino ("-NR₂"), mercapto ("-SH"), thioethers ("-SR"), thiocarbonyl ("-C(S)-"), phosphono ("PH₂"), (C₁-C₆)alkylphosphino ("-PHR"), di(C₁-C₆)alkylphosphino ("-PR₂"), vinyl ("C=C"), acetylenyl ("C≡C"), pyridyl, phenyl, furanyl, thiophenyl, aminophenyl, hydroxyphenyl, (C₁-C₆)alkylphenyl, di(C₁-C₆)alkylphenyl, (C₁-C₆)alkylphenol, (C₁-C₆)alkoxy-(C₁-C₆)alkylphenyl, biphenyl and bipyridyl. The electron donating group may include another electron donating group, as in hydroxyphenyl, aminophenyl and alkoxyphenyl.

A wide variety of anionic ligands (L¹) may be used in the present invention. Such ligands bear a negative charge. Possible ligands include, without limitation: hydride, halide, azide, alkyls, alkenyl, alkynyl, carbonyl, dialkylaminoalkyl, imino, hydrazido, phosphido, nitrosyl, nitryl, nitrite, nitrate, nitrile, alkoxy, dialkylaminoalkoxy, siloxy, diketonates, ketoiminates, cyclopentadienyls, silyls, pyrazolates, guanidinates, phosphoguanidinates, amidinates and phosphoamidinates. Any of such ligands may be optionally substituted such as by replacing one or more hydrogens with another substituent group such as halo, amino, disilylamino and silyl. Exemplary anionic ligands include, but are not limited to: (C₁-C₁₀)alkyl such as methyl, ethyl, propyl, butyl, pentyl, hexyl, cyclopropyl, cyclopentyl and cyclohexyl; (C₂-C₁₀)alkenyl such as ethenyl, allyl, and butenyl; (C₂-C₁₀)alkynyl such as acetylenyl and propynyl; (C₁-C₁₀)alkoxy such as methoxy, ethoxy, propoxy, and butoxy; cyclopentadienyls such as cyclopentadienyl, methylcyclopentadienyl and pentamethylcyclopentadienyl; di(C₁-C₁₀)alkylamino(C₁-C₁₀)alkoxy such as dimethylaminoethoxy, diethylaminoethoxy, dimethylaminopropoxy, ethylmethylaminopropoxy and diethylaminopropoxy; silyls such as (C₁-C₁₀)alkylsilyls and (C₁-C₁₀)alkylaminosilyls; and alkyl amidinates such as N,N'-dimethylmethylamidinato, N,N'diethyl-methylamidinato, N,N'-diethyl-ethylamidinato, N,N'-di-isopropyl-methylamidinato, N,N'-di-iso-propyl-iso-propylamidinato, and N,N'-dimethylphenylamidinato. When m ≥ 3 and EDG = amino, alkylamino, dialkylamino, pyridyl or alkoxy, at least one L¹ ligand is present in the organometallic compound, i.e. x' ≥ 1. Typically, up to five L¹ ligands may be present. In one embodiment, x' = 1-4. When 2 or more L¹ ligands are present, such ligands may be the same or different.

L² is a ligand chosen from amino, alkylamino, dialkylamino and alkoxyalkyldialkylamino. When m ≥ 3 and EDG = amino, alkylamino, dialkylamino, pyridyl or alkoxy, ligand L² is present. Exemplary ligands for L² include, without limitation, (C₁-C₁₀)alkylamino such as methylamino, ethylamino, and propylamino; di(C₁-C₁₀)alkylamino such as dimethylamino, diethylamino, ehtylmethylamino and dipropylamino.

Neutral ligands (L³) are optional in the present compounds. Such neutral ligands do not bear an overall charge and may function as stabilizers. Neutral ligands include, without limitation, CO, NO, alkenes, dienes, trienes, alkynes, and aromatic compounds. Exemplary neutral ligands include, but are not limited to: (C₂-C₁₀)alkenes such as ethene, propene, 1-butene, 2-butene, 1-pentene, 2-pentene, 1-hexene, 2-hexene, norbornene, vinylamine, allylamine, vinyltri(C₁-C₆)alkylsilane, divinyldi(C₁-C₆)alkylsilane, vinyltri(C₁-C₆)alkoxysilane and divinyldi(C₁-C₆)alkoxysilane; (C₄-C₁₂)dienes such as butadiene, cyclopentadiene, isoprene, hexadiene, octadiene, cyclooctadiene, norbornadiene and α-terpinene; (C₆-C₁₆)trienes; (C₂-C₁₀)alkynes such as acetylene and propyne; and aromatic compounds such as benzene, o-xylene, m-xylene, p-xylene, toluene, o-cymene, m-cymene, p-cymene, pyridine, furan and thiophene. The number of neutral ligands depends upon the particular metal chosen for M. Typically, the number of neutral ligands is from 0-3. When 2 or more neutral ligands are present, such ligands may be the same or different.

The present metal imino complexes may be prepared by a variety of methods known in the art. For example, the general procedure disclosed in U.S. Patent Application No. 2005/0202171 (Shin) for the manufacture of certain ethylmethylamino metal compounds may be employed to prepare the present organometallic compounds. Alternatively, the general procedures disclosed in International Patent Applications WO 2004/007796 and WO 2005/112101 for the manufacture of certain imino complexes may be easily modified by those skilled in the art to prepare the present metal imino complexes.

The above-described organometallic compounds are particularly suitable for use as precursors for the vapor phase deposition of thin films. Such compounds may be used in a variety of CVD processes as well as in a variety of ALD processes. In one embodiment, 2 or more of such organometallic compounds may be used in a CVD or ALD process. When 2 or more organometallic compounds are used, such compounds may contain the same metal but having different ligands, or may contain different metals. In another embodiment, one or more of the present organometallic compounds may be used with one or more other precursor compounds.

Bubblers (also known as cylinders) are the typical delivery devices used to provide the present organometallic compounds in the vapor phase to a deposition reactor. Such bubblers typically contain a fill port, a gas inlet port and an outlet port which is connected to a vaporizer that is connected to a deposition chamber if direct liquid injection is employed. The outlet port may be also directly connected to a deposition chamber. A carrier gas typically enters the bubbler through the gas inlet port and entrains or picks up precursor vapor or a precursor-containing gas stream. The entrained or carried vapor then exits the bubbler through the outlet port and is conveyed to the deposition chamber. A variety of carrier gases may be used, such as hydrogen, helium, nitrogen, argon and mixtures thereof.

A wide variety of bubblers may be used, depending upon the particular deposition apparatus used. When the precursor compound is a solid, the bubblers disclosed in U.S. Patent Nos. 6,444,038 (Rangarajan et al.) and 6,607,785 (Timmons et al.), as well as other designs, may be used. For liquid precursor compounds, the bubblers disclosed in U.S. Patent Nos. 4,506,815 (Melas et al) and 5,755,885 (Mikoshiba et al) may be used, as well as other liquid precursor bubblers. The source compound is maintained in the bubbler as a liquid or solid. Solid source compounds are typically vaporized or sublimed prior to transportation to the deposition chamber. Bubbler for use with ALD processes may have pneumatic valves at the inlet and outlet ports to facility opening and closing rapidly as required to provide the necessary vapor pulses.

In conventional CVD processes, a bubbler for supplying a liquid precursor, as well as certain bubblers for supplying solid precursors, will contain a dip tube which is connected to the gas inlet port. In general, the carrier gas is introduced below the surface of the organometallic compound, also called a precursor or source compound, and travels upward through the source compound to the headspace above it, entraining or carrying vapor of the source compound in the carrier gas.

Precursors used in ALD processes are often liquids, low melting solids, or solids formulated in a solvent. To handle these types of precursors, bubblers used in ALD processes may contain a dip tube connected to the outlet port. Gas enters these bubblers through the inlet, pressurizes the bubbler and forces the precursor up the dip tube and out of the bubbler.

The present invention provides a delivery device including the organometallic compound described above. In one embodiment, the delivery device includes a vessel having an elongated cylindrical shaped portion having an inner surface having a cross-section, a top closure portion and a bottom closure portion, the top closure portion having an inlet opening for the introduction of a carrier gas and an outlet opening, the elongated cylindrical shaped portion having a chamber containing the organometallic compound described above.

In an embodiment, the present invention provides a device for feeding a fluid stream saturated with an organometallic compound of the formula (EDG-(CR¹R²)_{y}-N=)ₙM^{+m}L¹_{x'}L²_{x"}L³ₚ, wherein each R¹ and R² are independently chosen from H, (C₁-C₆)alkyl and EDG; EDG is an electron donating group; M = a metal; L¹ = an anionic ligand; L² is a ligand chosen from amino, alkylamino, dialkylamino and alkoxyalkyldialkylamino; L³ = a neutral ligand; y = 0-6; m = the valence of M; n = 1-2; x' ≥ 0; x" ≥ 0; m = 2n + x' + x"; p = 0-3; wherein n = 1 when m = 2-3, and wherein n = 1-2 when m ≥ 4; L¹ ≠ L²; provided that x' ≥ 1 when m ≥ 3 and EDG = amino, alkylamino, dialkylamino, pyridyl or alkoxy to a chemical vapor deposition system including a vessel having an elongated cylindrical shaped portion having an inner surface having a cross-section, a top closure portion and a bottom closure portion, the top closure portion having an inlet opening for the introduction of a carrier gas and an outlet opening, the elongated cylindrical shaped portion having a chamber containing the organometallic compound; the inlet opening being in fluid communication with the chamber and the chamber being in fluid communication with the outlet opening. In a still further embodiment, the present invention provides an apparatus for chemical vapor deposition of metal films including one or more devices for feeding a fluid stream saturated with the organometallic compound described above.

The deposition chamber is typically a heated vessel within which is disposed at least one, and possibly many, substrates. The deposition chamber has an outlet, which is typically connected to a vacuum pump in order to draw by-products out of the chamber and to provide a reduced pressure where that is appropriate. Metalorganic CVD ("MOCVD") can be conducted at atmospheric or reduced pressure. The deposition chamber is maintained at a temperature sufficiently high to induce decomposition of the source compound. The typical deposition chamber temperature is from 200° to 1200° C, more typically 200-600° C, the exact temperature selected being optimized to provide efficient deposition. Optionally, the temperature in the deposition chamber as a whole can be reduced if the substrate is maintained at an elevated temperature, or if other energy such as plasma is generated by radio frequency ("RF") energy source.

Suitable substrates for deposition, in the case of electronic device manufacture, may be silicon, silicon germanium, silicon carbide, gallium nitride, gallium arsenide, indium phosphide, and the like. Such substrates are particularly useful in the manufacture of integrated circuits.

Deposition is continued for as long as desired to produce a film having the desired properties. Typically, the film thickness will be from several hundred to several thousand angstroms or more when deposition is stopped.

Thus, the present invention provides a method for depositing a metal film including the steps of: a) providing a substrate in a vapor deposition reactor; b) conveying as a precursor the organometallic compound described above is a gaseous form to the reactor; and c) depositing a film including the metal on the substrate. In a typical CVD process, the above described method further includes the step of decomposing the precursor in the reactor.

Thin metal-containing films are produced by ALD with almost perfect stoichiometry by alternately subjecting the substrate, one at a time, to the vapor of precursor compounds of each of the elements of which the film is formed. In ALD processes, a substrate is subjected to the vapor of a first precursor which can react with the surface of the substrate at a temperature sufficiently high for such reaction to occur whereby a single atomic layer of the first precursor (or metal contained therein) is formed on the surface of the substrate, and subjecting the thus formed surface with the first precursor atomic layer thereon to the vapor of a second precursor which reacts with the first precursor at a temperature sufficiently high for such reaction to occur whereby a single atomic layer of the desired metal film is formed on the surface of the substrate. This procedure can be continued by alternately using the first and second precursors until the film that is formed reaches a desire to thickness. The temperatures used in such ALD processes are typically lower than those employed in MOCVD process and may be in the range of 200 to 400° C, although other suitable temperatures may be employed depending upon the precursors chosen, the film to be deposited, and on other criteria known to those skilled in the art.

An ALD apparatus typically includes a vacuum chamber means to provide an evacuated atmosphere, a pair of means situated in the vacuum chamber means, the pair of means including a support means for supporting at least one substrate and a source means for forming sources for as least two vapors of two different precursors, respectively, and operating means operatively connected with one of the pair of means for operating the one means with respect to the other of the pair of means for providing on the substrate first a single atomic layer of one of the precursors and then a single atomic layer of the other precursor. See, e.g., U.S. Patent No. 4,058,430 (Suntola) for a description of an ALD apparatus.

In a further embodiment, the present invention provides a method of depositing a film including the steps of: providing a substrate in a vapor deposition reactor; conveying as a first precursor the organometallic compound described above in a gaseous form to the reactor; chemisorbing the first precursor compound on the surface of the substrate; removing any non-chemisorbed first precursor compound from the reactor; conveying a second precursor in a gaseous form to the reactor; reacting the first and second precursors to form a film on the substrate; and removing any unreacted second precursor. The alternating steps of conveying the first and second precursors and step of reacting the first and second precursors being repeated until a film of the desired thickness is obtained. The step of removing a precursor from the reactor may include one or more of evacuating the reactor under vacuum and purging the reactor using a non-reactant gas and/or multiple solvent vapor. The second precursor may be any suitable precursor that reacts with the first precursor to form the desired film. Such second precursors may optionally contain another metal. Exemplary second precursors include, but are not limited to, oxygen, ozone, water, hydrogen peroxide, alcohols, nitrous oxide and ammonia.

When the present organometallic compounds are to be used in ALD processes or in direct liquid injection processes, they may be combined with an organic solvent. Any organic solvent which is suitably inert to the organometallic compound. Exemplary organic solvents include, without limitation, aliphatic hydrocarbons, aromatic hydrocarbons, linear alkyl benzenes, halogenated hydrocarbons, silyated hydrocarbons, alcohols, ethers, glymes, glycols, aldehydes, ketones, carboxylic acids, sulphonic acids, phenols, esters, amines, alkylnitrile, thioethers, thioamines, cyanates, isocyanates, thiocyanates, silicone oils, nitroalkyl, alkylnitrate, and mixtures thereof. Suitable solvents include tetrahydrofuran, diglyme, n-butyl acetate, octane, 2-methoxyethyl acetate, ethyl lactate, 1,4-dioxane, vinyltrimethylsilane, pyridine, mesitylene, toluene, and xylene. When used in direct liquid injection processes, the concentration of the organometallic compound is typically in the range of 0.05 to 0.25 M, and more typically 0.05 to 0.15 M. The organometallic compound/organic solvent compositions may be in the form of solutions, slurries or dispersions.

Compositions including the present organometallic compound and an organic solvent are suitable for use in vapor deposition processes employing direct liquid injection. Suitable direct liquid injection processes are those described in U.S. Patent Application No. 2006/0110930 (Senzaki).

Further provided by the present invention is a method for manufacturing an electronic device including the step of depositing a metal-containing film using any one of the above described methods.

The present invention provides an enabling solution to the use of heteroleptic precursors for vapor deposition, particularly ALD, which have a suitable balance of functionality, desired thermal stability, appropriate metal center shielding and well governed surface as well as gas phase reactions, by use of phosphoamidinate ligands.

The following examples are expected to illustrate various aspects of the present invention.

### Example 1

Tantalum bis(di-isopropylacetamidinate)-(dimethylamino)-(2-diisopropylamino)-ethylimide, (i-Pr)₂NCH₂CH₂NTa(amd)₂(NMe₂), is expected to be synthesized as follows:

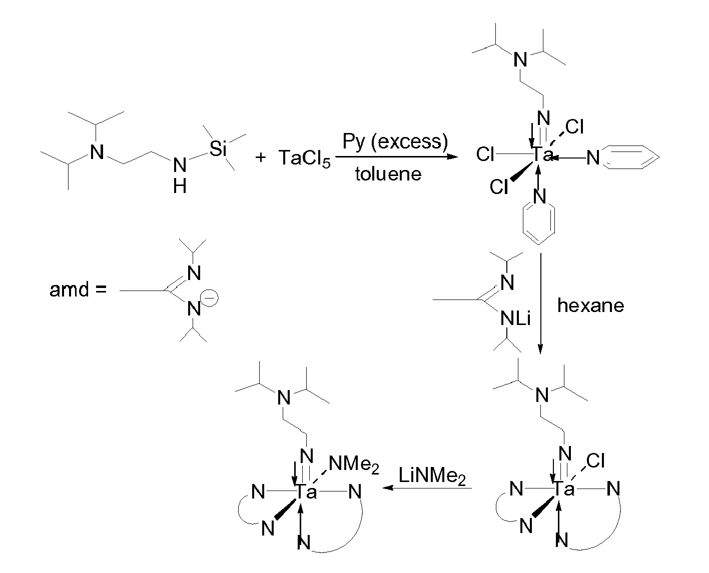

(2-Diisopropylaminoethyl)(trimethylsilyl)amine is added to TaCl₅ in toluene at low temperature (approximately -30 to -40° C). A 3-neck round bottom flask is used. It is equipped with magnetic or mechanical stirring and effective heating/cooling system to control the rate of reaction. After the mixture is stirred for 1 hour at room temperature, excess pyridine is added. The resulting mixture is then stirred overnight under an inert atmosphere of nitrogen. The reagents are added in continuous and dropwise manner, and are allowed to mix slowly to control the exothermicity of the reaction. The crude intermediate product is then expected to separate from the reaction mass after filtration with a high yield expected. Next, the intermediate is taken into hexane. To this, lithium di-isopropyl acetamidinate (Li-amd, which is prepared from N, N'-diisopropylcarbodiimide and methyl lithium in diethyl ether) suspended in hexane is added slowly. The mixture is expected to turn brown gradually as it is stirred overnight. Lithium dimethylamide which is prepared from dimethylamine and n-butyl lithium in hexane is then added to the reaction mixture. After filtration, the filtrate is concentrated. Purification by vacuum distillation is expected to give a pure compound. The target product is expected to be obtained in high yield and is expected to be substantially free of organic solvents (< 0.5 ppm) as determined by FT-NMR and also substantially free of metallic impurities (< 10 ppb) as determined by ICP-MS/ICP-OES.

### Example 2

Bis(2-diisopropylaminoethylimino)-bis(dimethylamino)tungsten(VI) is expected to be synthesized according to the following reaction scheme..

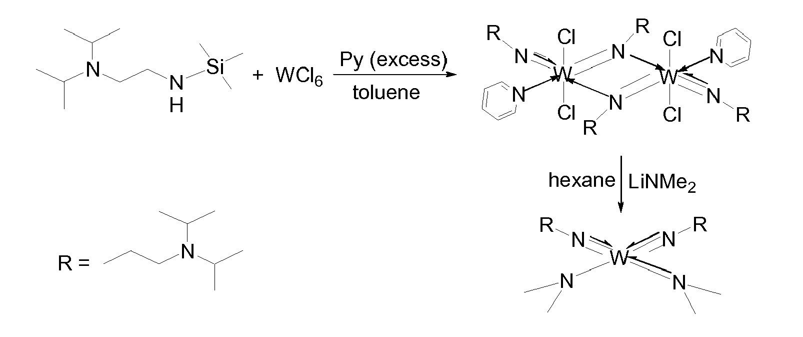

(2-Diisopropylaminoethyl)(trimethylsilyl)amine is slowly added to WCl₆ in toluene at low temperature (approximately -30 to -40° C). A 3-neck round bottom flask is used. It is equipped with magnetic or mechanical stirring and effective heating/cooling system to control the rate of reaction. After the mixture is stirred for a few hours at room temperature, excess pyridine is added. The resulting mixture is then stirred overnight under an inert atmosphere of nitrogen. The reagents are added in continuous and dropwise manner, and are allowed to mix slowly to control the exothermicity of the reaction. The crude intermediate product is then expected to separate from the reaction mass after filtration with a high yield expected. Next, the intermediate is taken into hexane. To this, LiNMe₂ suspended in hexane or LiNMe₂ powder which is prepared from dimethylamine and n-butyl lithium in hexane is added slowly. The mixture is expected to turn dark brown as it is stirred overnight. After filtration, the filtrate is concentrated. Purification by vacuum distillation is expected to give the desired compound. The target product is expected to be obtained in reasonably high yield and is expected to be substantially free of organic solvents (< 0.5 ppm) as determined by FT-NMR and also substantially free of metallic impurities (< 10 ppb) as determined by ICP-MS/ICP-OES.

### Example 3

Organometallic compounds of the formula (EDG-(CR¹R²)_{y}-N=)ₙM^{+m}L¹_{x'}L²_{x"}L³ₚ listed in the following table are expected to be prepared according to the procedures in one or more of U.S. Patent Application No. 2004/0202171, and International Patent Applications WO

| **Sample** | **M** | **n** | **EDG** | **y** | **R¹** | **R²** | **L¹** | **L²** | **L³** |
|---|---|---|---|---|---|---|---|---|---|
| A | Mg | 1 | N(Et)Me | 0 | - | - | OEt | - | - |
| B | A1 | 1 | CH=C(Et)Me | 0 | - | - | H | - | - |
| C | Si | 1 | O-C(O)Me | 0 | - | - | AMD | - | - |
| D | Te | 2 | Py | 0 | - | - | KIM | - | - |
| E | Cu | 1 | N(H)-C(O)Et | 0 | - | - | PAMD | - | VTMS |
| F | Sc | 1 | OH | 0 | - | - | N(Et)Me | - | - |
| G | La | 1 | OK | 0 | - | - | DMAE | - | - |
| H | Ti | 1 | N(Me)Li | 0 | - | - | Cp | - | - |
| I | Hf | 1 | NH(t-Bu) | 0 | - | - | NO₃ | - | isoprene |
| J | V | 1 | BiPy | 0 | - | - | MMP | - | - |
| K | Ta | 1 | Ph | 0 | - | - | MP | - | - |
| L | W | 2 | Ph-NMe₂ | 0 | - | - | BDK | - | - |
| M | Ni | 1 | NH₂ | 1 | H | H | Pyrazo | - | Bz, CO |
| N | W | 2 | NMe₂ | 2 | H, Me | H, H | O-i-Pr | NMe₂ | - |

AMD = N,N'-dimethyl-methyl-amidinate; PAMD = N,P-dimethyl-methylphosphoamidinate; KIM = β-diketiminate; DMAE = dimethylaminoethyl; MMP = 1-methoxy-2-methyl-propoxy; MP = N-methylpyrrolidine;

In the above table, ligands separated by a comma denote that each ligand is present in that compound.

### Example 4

Compositions suitable for use in ALD or direct liquid injection processes are prepared by combining certain of the compounds of Example 3 with certain organic solvents. The particular compositions are shown in the following table. The organometallic compounds are typically present in a concentration of 0.1 M for direct liquid injection.

| **Composition Sample** | **Organometallic Compound Sample** | **Solvent** |
|---|---|---|
| 1 | D | THF |
| 2 | D | 1,4-Dioxane |
| 3 | D | 2-Methoxyethyl acetate |
| 4 | E | Diglyme |
| 5 | E | Octane |
| 6 | F | THF |
| 7 | F | Diglyme |
| 8 | G | Octane |
| 9 | G | THF |
| 10 | G | n-Butyl acetate |
| 11 | H | n-Butyl acetate |
| 12 | H | 2-Methoxyethoxy acetate |
| 13 | I | THF |
| 14 | J | Octane |
| 15 | K | Diglyme |
| 16 | L | n-Butyl acetate |
| 17 | M | 2-Methoxyethoxy acetate |
| 18 | M | Octane |
| 19 | N | THF |

## Claims

1. An organometallic compound having the formula
(EDG-(CR¹R²)_{y}-N=)ₙM^{+m}L¹_{x'}L²_{x"}L³ₚ, wherein each R¹ and R² are independently chosen from H, (C₁-C₆)alkyl and EDG; EDG is an electron donating group; M = a metal; L¹ = an anionic ligand; L² is a ligand chosen from amino, alkylamino, dialkylamino and alkoxyalkyldialkylamino; L³ = a neutral ligand; y = 0-6; m = the valence of M; n = 1-2; x' ≥ 0; x" ≥ 0; m = 2n + x' + x"; p = 0-3; wherein n = 1 when m = 2-3, and wherein n = 1-2 when m ≥ 4; L¹ ≠ L²; provided that x' ≥ 1 when m ≥ 3 and EDG = amino, alkylamino, dialkylamino, pyridyl or alkoxy.

2. The compound of claim 1 wherein L¹ is chosen from hydride, halide, azide, alkyls, alkenyl, alkynyl, carbonyl, dialkylaminoalkyl, imino, hydrazido, phosphido, nitrosyl, nitryl, nitrate, nitrile, alkoxy, dialkylaminoalkoxy, siloxy, diketonates, ketoiminates, cyclopentadienyls, silyls, pyrazolates, guanidinates, phosphoguanidinates, amidinates and phosphoamidinates.

3. The compound of claim 1 wherein EDG comprises one or more of oxygen, phosphorus, sulfur, nitrogen, alkenes, alkynes and aryl groups.

4. The compound of claim 1 wherein M is chosen from a Group 2 to Group 16 metal.

5. A composition comprising the compound of claim 1 and an organic solvent.

6. A method of depositing a film comprising the steps of: providing a substrate in a vapor deposition reactor; conveying as a precursor the organometallic compound of claim 1 in a gaseous form to the reactor; and depositing a film comprising the metal on the substrate.

7. A method of depositing a film comprising the steps of: providing a substrate in a reactor; conveying the composition of claim 5 into the reactor using direct liquid injection; and depositing a film comprising the metal on the substrate.

8. A method of depositing a film comprising the steps of: providing a substrate in a vapor deposition reactor; conveying as a first precursor the organometallic compound of claim 1 in a gaseous form to the reactor; chemisorbing the first precursor compound on the surface of the substrate; removing any non-chemisorbed first precursor compound from the reactor; conveying a second precursor in a gaseous form to the reactor; reacting the first and second precursors to form a film on the substrate; and removing any unreacted second precursor.

9. The method of claim 8 wherein the second precursor is chosen from oxygen, ozone, water, peroxide, alcohols, nitrous oxide and ammonia.

10. A delivery device for delivering a precursor in the vapor phase to a vapor deposition reaction comprising the compound of claim 1.
